Europäisches Patentamt

European Patent Office

Office européen des brevets

(11) Numéro de publication: **0 323 932**
**A1**

(12) ## DEMANDE DE BREVET EUROPEEN

(21) Numéro de dépôt: 89400024.9

(22) Date de dépôt: 04.01.89

(51) Int. Cl.⁴: **G 11 C 19/08**

(30) Priorité: 05.01.88 FR 8800032

(43) Date de publication de la demande:
**12.07.89 Bulletin 89/28**

(84) Etats contractants désignés: **DE GB NL**

(71) Demandeur: **COMMISSARIAT A L'ENERGIE ATOMIQUE**
**31/33, rue de la Fédération**
**F-75015 Paris (FR)**

(72) Inventeur: **Fedeli, Jean-Marc**
**3 rue Bach**
**F-38120 Le Fontanil (FR)**

**Magnin, Joel**
**3 rue Doyen Gosse**
**F-38400 Saint Martin D'Heres (FR)**

**Delaye, Marie-Thérèse**
**3 Allée de la Pelouse**
**F-38100 Grenoble (FR)**

**Rabarot, Marc**
**4 rue Pierre Ruibet**
**F-38000 Grenoble (FR)**

(74) Mandataire: **Mongrédien, André et al**
**c/o BREVATOME 25, rue de Ponthieu**
**F-75008 Paris (FR)**

(54) **Mémoire à bulles magnétiques en technologie hybride.**

(57) Mémoire à bulles magnétiques en technologie hybride utilisant des rangées de motifs de chevrons.

L'ensemble de détection de la mémoire comporte une zone de détection active (4) constituée de rangées de chevrons, pour étirer sous la forme d'une bande, les bulles issues d'un chemin de propagation (2), et un premier détecteur (8) ; une zone d'élimination (12) des bulles composées de rangées de refoulement (18) pour stopper la progression des bulles et les repousser à l'extérieur de l'ensemble de détection, et une zone de détection passive (6) placée après la zone d'élimination des bulles (12) comprenant un deuxième détecteur (10) auquel aucune bulle ne doit être soumise, afin d'éliminer le signal parasite dû à l'influence d'un champ magnétique tournant nécessaire à la propagation des bulles.

Selon l'invention, la zone d'élimination (12) est munie d'au moins une barrière (20) réalisée en implantation ionique pour bloquer le passage aux bulles de la zone active (4) vers la zone passive (6). La ou les barrières (20, 22, 26, 28, 30) peuvent être constituées d'une implantation énergétique d'ions $H_2^+$.

FIG. 3

**Description**

## MEMOIRE A BULLES MAGNETIQUES EN TECHNOLOGIE HYBRIDE

L'invention concerne, dans le domaine des mémoires à bulles magnétiques en technologie hybride, la détection des bulles magnétiques dans un ensemble de détection faisant appel à l'utilisation de rangées de chevrons et constitué par une zone de détection active et une zone de détection passive.

Dans une mémoire à bulles magnétiques, celles-ci sont contenues dans une couche magnétique monocristalline, supportée par un grenat monocristallin amagnétique. Ces bulles se présentent sous la forme de domaines magnétiques isolés, généralement cylindriques, et présentant une aimantation inverse de celles du reste de la couche magnétique monocristalline.

Par application d'un champ magnétique continu, perpendiculaire au plan de la couche magnétique, les bulles magnétiques sont stables. Dans la pratique, ce champ magnétique peut être créé par un aimant permanent, assurant ainsi la non volatilité des informations contenues dans la mémoire à bulles. En appliquant par ailleurs un champ magnétique continu tournant, suivant un plan parallèle à la surface de la couche magnétique, on peut réaliser le déplacement des bulles. Ce dernier se fait autour de motifs de propagation. Ces motifs peuvent être réalisés en un matériau à base de fer et de nickel appelé permalloy et déposé sur une couche isolante recouvrant la couche magnétique. Ces motifs peuvent être des chevrons. Le permalloy est un alliage de nickel (environ 80%) et de fer (environ 20%). Il se caractérise par une haute perméabilité magnétique (environ 50 fois celle du fer pur dans de faibles champs magnétiques). Ces motifs peuvent être également obtenus en implantant des ions dans la partie supérieure de la couche magnétique, à travers un masque permettant de définir leur forme.

Le déplacement des bulles, le long de ces motifs, se fait généralement pendant une durée égale au tiers de la période de rotation du champ magnétique tournant, les bulles restant immobiles dans les espaces définis entre deux motifs adjacents, pendant le reste du cycle. On réalise ainsi des registres à décalage dans lesquels l'information binaire "1" est représentée par la présence d'une bulle et l'information binaire "0" par l'absence d'une bulle.

La sortie d'une mémoire à bulles est constituée d'un chemin de propagation aboutissant à un ensemble de détection, qui constitue un moyen de lecture de la mémoire. Un ensemble de détection de bulles magnétiques est formé d'une zone de détection active et d'une zone de détection passive.

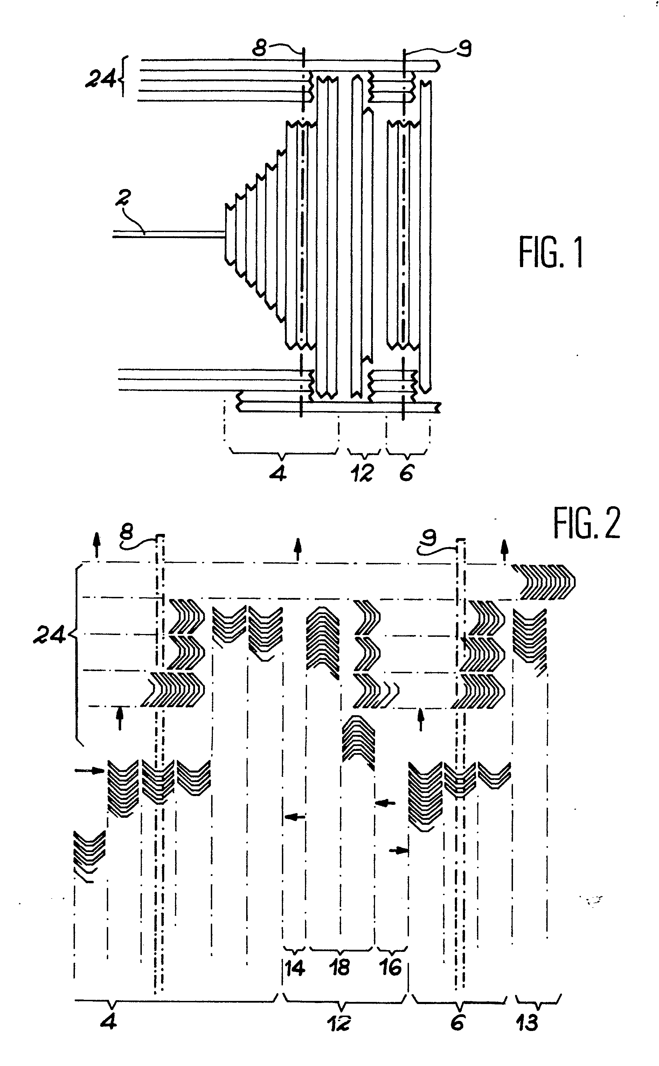

En référence à la figure 1, le chemin de propagation 2, constitué d'une succession de motifs s'apparentant à des chevrons, conduit les bulles contenant l'information à lire vers la zone active 4. Celle-ci est composée de rangées de motifs, du même type contenant, par exemple, successivement un nombre croissant de motifs. Chaque bulle magnétique qui arrive dans cette zone active 4, est donc étirée sous la forme d'une bande, sous l'action de ces rangées de chevrons. Elle se propage sous cette forme jusqu'à un détecteur 8, placé sur toute la largeur de la zone active. La bulle magnétique, sous cette forme de bande, influence le détecteur 8, et permet d'obtenir un signal de détection. Le signal détecté est la somme du signal produit par la bande étirée et du signal parasite induit par le champ tournant. Le détecteur 8 est formé par un barreau magnéto-résistif intercalé entre la couche magnétique contenant les bulles et les chevrons.

Afin d'éliminer ce signal parasite, on associe au détecteur actif 8, un détecteur identique dit passif 9, qui ne devra être influencé que par le champ tournant. Pour cela, la zone de détection passive 6 qui le contient doit être exempte de toute bulle ou bande (bulle étirée). Ainsi, par amplification différentielle du signal issu du détecteur actif 8 et du signal issu du détecteur passif 9, on élimine le signal parasite induit par le champ tournant et on obtient uniquement le signal induit par les bulles magnétiques.

Pour éviter aux bulles magnétiques et en particulier aux bulles étirées dans la zone active 4 de pénétrer dans la zone passive 6, des zones d'élimination 12, 13, 24 des bulles est prévue autour de la zone passive 6 et en particulier entre les zones active et passive.

Ces zones d'élimination peuvent comporter des zones de confinement, des zones de refoulement et des espaces, ces derniers permettant d'éviter l'accrochage éventuel de bulles ou bandes se propageant dans la zone passive (ou active) sur les zones de refoulement.

Sur la figure 1, on a représenté la zone de détection passive 6 située après la zone de détection active par rapport au chemin de propagation 2, mais bien entendu, la zone de détection passive 6 peut être située n'importe où dans l'ensemble de détection, à condition que l'axe du détecteur 9 soit toujours parallèle à l'axe du détecteur actif pour que le signal dû au champ magnétique tournant soit le même pour les détecteurs actif et passif.

La zone de détection passive peut en particulier être dans l'axe du détecteur actif 8.

Dans l'agrandissement d'une réalisation préférentielle représentée figure 2, une zone de confinement 14 a été représentée, bordant la zone active 4. Une zone de refoulement 18 est prévue entre la zone de confinement 14 et un espace 16 bordant la zone passive 6. Ces zones 14, 16, 18 constituent la zone d'élimination 12 située entre les zones passive et active. Cette zone de refoulement 18 est constituée d'une ou plusieurs rangées de chevrons orientés dans un sens opposé à l'orientation des chevrons de la zone active 4 et la zone passive 6, ceci dans le but de faire obstacle au passage éventuel des bulles magnétiques vers la zone passive 6. Les bulles magnétiques étirées et détectées dans la zone active 4, soit se désagrègent entièrement dans la zone de confinement 14, soit, toujours sous forme de bulles, sortent de la zone de confinement 14 à l'extérieur de l'ensemble de détection, cette sortie étant favorisée par une zone de refoulement latérale 24, placée sur chaque côté des zones active et passive, et dont les chevrons sont orientés dans une direction perpendiculaire à la direction d'orientation des chevrons dans la zone active 4 et passive 6, et de telle sorte que les bulles magnétiques soient refoulées de l'intérieur vers l'extérieur des zones active et passive.

Par ailleurs, une zone d'élimination 13 constituée d'une zone de refoulement est prévue derrière la zone de détection passive.

L'efficacité des zones d'élimination 12, 13, 24 des bulles magnétiques ne s'avère pas suffisante car quelques bulles parasites pénètrent dans la zone passive 6 malgré en particulier la zone de refoulement 18 et l'espace 16 et sont détectées par le deuxième détecteur passif 9. Ceci fausse le résultat issu de la combinaison des signaux des détecteurs actif 8 et passif 9.

Le but de l'invention est d'augmenter l'efficacité des zones d'élimination et en particulier de la zone 12, pour améliorer la protection de la zone passive 6.

A cet effet, l'objet principal de l'invention est une mémoire à bulles magnétiques en technologie hybride utilisant des rangées de motifs de chevrons, et dont l'ensemble de détection comporte :
- une zone active constituée, de rangées de chevrons orientés dans un premier sens déterminé pour étirer sous la forme d'une bande des bulles issues d'un chemin de propagation et d'un premier détecteur magnéto-résistif auquel est soumise chaque bulle étirée ;
- une zone passive placée au voisinage de la zone active, constituée de rangées de chevrons orientés dans le premier sens et d'un deuxième détecteur magnéto-résistif, auquel aucune bulle ne doit être soumise, dans le but d'éliminer le signal parasite dû à l'influence d'un champ magnétique tournant nécessaire à la propagation des bulles ; et
- un ensemble de zones d'élimination des bulles permettant de repousser les bulles à l'extérieur de l'ensemble de détection, lesdites zones entourant entièrement la zone passive et partiellement la zone active.

Selon l'invention, cet ensemble de zones d'élimination est muni d'au moins une barrière réalisée en implantation ionique, pour bloquer le passage aux bulles vers la zone passive, cette barrière étant située devant la zone passive. De cette manière, seul le champ magnétique tournant influence le détecteur passif. Les signaux issus des détecteurs passif et actif étant combinés, seul le signal parasite dû au champ magnétique tournant sera complètement éliminé du signal délivré par l'ensemble de détection.

Selon l'invention, la barrière est, de façon préférentielle, perpendiculaire à la direction de propagation des bulles dans la zone active. Il est même avantageux que cette barrière s'étende sur toute la largeur de l'ensemble de détection lorsque la zone passive est placée derrière la zone active de façon à ce que les extrémités de la barrière soient situées dans les zones d'élimination latérales.

L'ensemble de détection comporte des zones d'élimination latérales composées de rangées de chevrons orientés dans une direction perpendiculaire à la direction d'orientation des chevrons dans la zone active et tels qu'ils permettent d'évacuer des bulles, l'invention prévoit de disposer au moins une première barrière supplémentaire dans les zones d'élimination latérales, perpendiculairement à la direction d'évacuation des bulles, pour empêcher le passage de bulles à l'intérieur de la zone passive.

Il est également prévu de disposer une deuxième barrière supplémentaire en bordure de la zone active de l'ensemble de détection dans les zones d'élimination latérales, pour empêcher l'intrusion de bulles parasites venant de l'extérieur de l'ensemble de détection dans la zone active.

Selon une réalisation particulière de l'invention, la ou les barrières sont constituées d'une implantation d'ions. Ces ions implantés sont de préférence des ions d'hydrogène. Ils sont implantés dans la couche magnétique contenant les bulles.

L'invention et ses caractéristiques seront mieux comprises à la lecture de la description qui va suivre, accompagnée des figures suivantes, .représentant respectivement :
- la figure 1, déjà évoquée, représente un schéma d'un exemple de structure d'un ensemble de détection de mémoire à bulles selon l'art antérieur ;
- la figure 2 représente un agrandissement partiel de la figure 1 ;
- la figure 3 représente schématiquement un exemple d'un ensemble de détection d'une mémoire à bulles selon l'invention ;

La structure d'un ensemble de détection d'une mémoire à bulles selon l'art antérieur, représentée sur la figure 1, comporte les principaux éléments suivants. Un chemin de propagation 2, permet aux bulles magnétiques d'accéder à une zone de détection active 4. Cette dernière est par exemple suivie d'une zone d'élimination 12 des bulles magnétiques, et d'une zone de détection passive 6. Les deux zones de détection active 4 et passive 6 et le chemin de propagation 2 sont constituées de motifs de permalloy, s'apparentant à des chevrons, et alignées de manière à constituer des rangées formant des chemins de déplacement pour les bulles magnétiques.

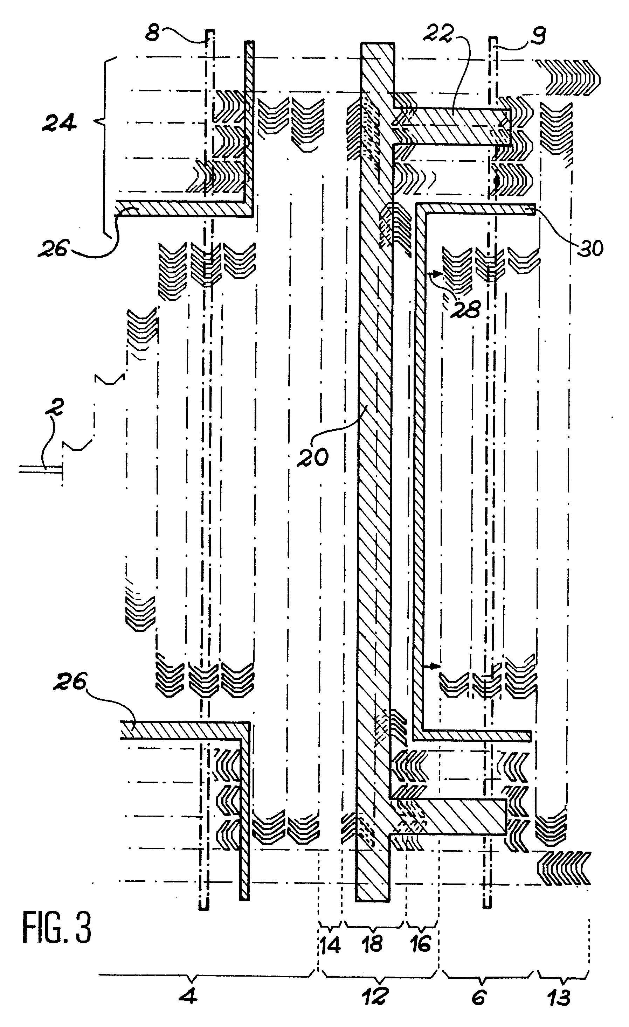

Comme représenté sur la figure 3, la structure d'une mémoire à bulles selon l'invention reprend la structure d'une mémoire à bulles selon l'art antérieur, décrit précédemment. On y retrouve les deux zones de détection active 4 et passive 6, ainsi que leurs détecteurs respectifs 8 et 9, et que l'ensemble de zones d'élimination 12 des bulles magnétiques qui sépare les deux zones de détection 4 et 6.

Selon l'invention, et pour renforcer l'efficacité de cet ensemble de zones d'élimination, on utilise une barrière 20 se situant dans la zone de refoulement 18 de cet ensemble de zones d'élimination 12. Cette barrière est réalisée en une implantation ionique et constitue un mur qui empêche tout passage de bulles magnétiques en particulier de la zone active 4 vers la zone passive 6. Sur les bords du motif, réalisé par implantation ionique, et qui constituent cette barrière, on obtient des puits de champ magnétique qui piègent les bulles, et bloquent leur passage d'une zone à l'autre, dans les conditions normales de fonctionnement. Cette barrière est orientée perpendiculairement à la direction de propagation des bulles dans la zone active 4. Elle peut s'étendre sur toute la largeur de l'ensemble de détection.

L'ensemble de détection comporte de manière générale sur chacun de ses côtés une zone d'élimination latérale 24 composée de rangées de chevrons orientés dans une direction perpendiculaire à la direction d'orientation des chevrons dans la zone active 4, et tels qu'ils permettent d'évacuer les bulles. Afin d'éviter que certaines bulles ne pénètrent dans la zone passive au niveau de cette zone latérale 24, on prévoit de compléter la barrière 20 d'une première barrière supplémentaire 22, disposée au voisinage de la zone passive dans les zones latérales 24, perpendiculairement à la direction d'évacuation des bulles dans ces zones.

Pour renforcer l'efficacité du système, on peut également ajouter une deuxième barrière supplémentaire 26 en bordure de la zone active 4, pour empêcher l'intrusion de bulles parasites, venant de l'extérieur de l'ensemble de détection, dans la zone active et de façon plus précise entre les zones de refoulement latérales et la zone active.

Une deuxième barrière principale 28 a été représentée, en doublure de la première barrière 20. Elle est située dans l'espace 16. Elle peut également être complétée d'une partie 30, perpendiculaire à la direction de la partie principale de cette deuxième barrière et située entre les zones de refoulement latérales et la zone passive dans les zones d'élimination.

Ces différentes barrières permettent d'améliorer les marges de fonctionnement du dispositif en éliminant tout signal issu de bande venant du détecteur passif.

Les différentes barrières prévues dans le dispositif selon l'invention, sont constituées d'une implantation d'ions effectuée avant les zones de détection active et passive et en particulier avant les détecteurs et les rangées de chevrons. Ces ions sont, de préférence, des ions d'hydrogène $H_2^+$, implantés par bombardement ionique avec une dose d'environ $4.10^{16}$ atomes par cm$^3$, et une énergie de 80 KeV. Cette implantation s'effectue à l'aide de cache, recouvrant au cours de l'implantation les parties de la couche magnétique qui seront exemptes de toute implantation. En bordure de ces zones, on obtient un profil de contrainte dû à l'augmentation de la maille cristalline dans les zones implantées. On obtient alors une barrière de potentiel magnétique. Les bulles se positionnent en bordure des zones implantées, qui constituent des puits d'énergie. En l'absence de toute variation magnétique exceptionnelle, le passage des bulles magnétiques d'une zone à l'autre est impossible.

**Revendications**

1. Mémoire à bulles magnétiques en technologie hybride en utilisant des rangées de motifs de chevrons et dont l'ensemble de détection comporte :
- une zone de détection active (4) constituée de rangées de chevrons orientés dans un premier sens déterminé pour étirer sous la forme d'une bande, les bulles issues d'un chemin de propagation (2), et un premier détecteur (8) magnétorésistif auquel est soumise chaque bulle étirée ;
- une zone de détection passive (6) placée au voisinage de la zone active (4) et constituée de rangées de chevrons orientés dans ledit premier sens, et un deuxième détecteur magnétorésistif (10) auquel aucune bulle ne doit être soumise, afin d'éliminer le signal parasite dû à l'influence d'un champ magnétique tournant nécessaire à la propagation des bulles, et
- un ensemble de zones d'élimination (12) des bulles permettant de repousser les bulles à l'extérieur de l'ensemble de détection, lesdites zones entourant entièrement la zone passive (6) et partiellement la zone active (4),
caractérisée en ce que l'ensemble de zones d'élimination (12) est munie d'au moins une barrière (20) réalisée en implantation ionique pour bloquer le passage aux bulles vers la zone passive (6), cette barrière (20) étant située devant la zone passive (6).

2. Mémoire selon la revendication 1, caractérisée en ce que ladite barrière (20) est perpendiculaire à la direction de propagation des bulles dans la zone active (4).

3. Mémoire selon la revendication 1 ou 2, caractérisée en ce que ladite barrière (20) s'étend sur toute la largeur de l'ensemble de détection.

4. Mémoire selon l'une quelconque des revendications précédentes, dont l'ensemble de détection comporte des zones latérales d'élimination (24) composées de rangées de chevrons orientés dans une direction perpendiculaire au sens d'orientation des chevrons dans la zone active (4) pour évacuer des bulles, caractérisée en ce qu'au moins une première barrière supplémentaire (22) est disposée dans les zones d'élimination latérales, perpendiculairement à la direction d'évacuation des bulles, pour empêcher le passage des bulles vers l'intérieur de la zone passive (6).

5. Mémoire selon l'une quelconque des revendications précédentes, caractérisée en ce qu'au moins une deuxième barrière supplémentaire (26) est prévue en bordure de la zone active (4) de l'ensemble de détection, dans les zones d'élimination latérales, pour empêcher l'intrusion de bulles parasites venant de l'extérieur dans la zone active (4).

6. Mémoire selon l'une quelconque des revendications précédentes, caractérisée en ce que la ou les barrières (20, 22, 26, 28, 30) sont constituées d'une implantation d'ions.

7. Mémoire selon la revendication 6, caractérisée en ce que les ions implantés sont des ions

d'hydrogène ($H_2^+$), implantés dans la couche magnétique contenant les bulles.

FIG. 1

FIG. 2

FIG. 3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | GB-A-2 161 002 (HITACHI) <br> * Page 11, lignes 8-21; figure 6 * <br> --- | 1,4 | G 11 C 19/08 |
| A | PATENT ABSTRACTS OF JAPAN, vol. 6, no. 100 (P-121)[978], 9 juin 1982, page P 121; & JP-A-57 33 486 (OKI DENKI KOGYO K.K.) 23-02-1982 <br> --- | 1 | |
| A | PATENT ABSTRACTS OF JAPAN, vol. 7, no. 216 (P-225)[1361], 24 septembre 1983, page 166 P 225; & JP-A-58 111 181 (HITACHI SEISAKUSHO K.K.) 02-07-1983 <br> ----- | 1 | |

**DOMAINES TECHNIQUES RECHERCHES (Int. Cl.4)**

G 11 C 19/08

**Le présent rapport a été établi pour toutes les revendications**

| Lieu de la recherche | Date d'achèvement de la recherche | Examinateur |
|---|---|---|
| LA HAYE | 30-03-1989 | DEGRAEVE L.W.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P0402)